# EUROPEAN PATENT APPLICATION

(11) **EP 2 667 422 A2**
(43) Date of publication of application: **27.11.2013**
(21) Application number: 13156330.6
(22) Date of filing: 22.02.2013
(51) Int. Cl.: H01L 33/48, H01L 23/00

(54) **Semiconductor light emitting device**

(30) Priority: 25.05.2012 JP 2012120068
(71) Applicant: Kabushiki Kaisha Toshiba, Tokyo (JP)
(72) Inventor: Shimada, Miyoko, Tokyo (JP); Kojima, Akihiro, Tokyo (JP); Akimoto, Yosuke, Tokyo (JP); Tomizawa, Hideyuki, Tokyo (JP); Furuyama, Hideto, Tokyo (JP); Sugizaki, Yoshiaki, Tokyo (JP)
(74) Representative: HOFFMANN EITLE

(57) **Abstract**

According to an embodiment, a semiconductor light emitting device includes a semiconductor layer (15), a p-side electrode (16), an n-side electrode (17) and an insulating layer (40). The semiconductor layer (15) has a first face (15a) and a second face (15b) opposite to the first face (15a), and includes a light emitting layer (13). The p-side electrode (16) is provided in a region including the light emitting layer (13) on the second face side (15b), and the n-side electrode (17) is provided in a region not including the light emitting layer (13) on the second face side (15b). The insulating layer (40) covers the semiconductor layer (15), the p-side electrode (16), and the n-side electrode (17) on the second face side (15b), and includes at least a portion containing a magnetic substance (27).

## Description

### FIELD

Embodiments are related generally to a semiconductor light emitting device.

### BACKGROUND

Semiconductor light emitting devices are becoming popular as light sources of low power consumption and long lifetime. Particularly, the semiconductor light emitting device with chip size package is small, and may be adapted to various applications. However, such a device often causes a troublesome issue in assembling. Therefore, a semiconductor light emitting device is demanded to be small and superior to be handled.

### BRIEF DESCRIPTION OF THE DRAWINGS

FIG. 1 is a schematic view illustrating a semiconductor light emitting device according to a first embodiment;
FIGS. 2A to 13B are schematic views illustrating a manufacturing process of the semiconductor light emitting device according to the first embodiment;
FIGS. 14A and 14B are schematic views illustrating an assembling process of the semiconductor light emitting devices according to the first embodiment;
FIGS. 15A to 15C are schematic views illustrating another assembling process of the semiconductor light emitting devices according to the first embodiment;
FIGS. 16A and 16B are schematic cross-sectional views illustrating semiconductor light emitting devices according to variations of the first embodiment;
FIGS. 17A to 17C are schematic views illustrating a semiconductor light emitting device according to a second embodiment; and
FIG. 18 is a schematic cross-sectional view illustrating the light emitting device shown in FIGS 17A to 17C, which is mounted on a substrate.

### DETAILED DESCRIPTION

According to an embodiment, a semiconductor light emitting device includes a semiconductor layer, a p-side electrode, an n-side electrode and an insulating layer. The semiconductor layer has a first face and a second face opposite to the first face, and includes a light emitting layer. The p-side electrode is provided in a region including the light emitting layer on the second face side, and the n-side electrode is provided in a region not including the light emitting layer on the second face side. The insulating layer covers the semiconductor layer, the p-side electrode, and the n-side electrode on the second face side, and includes at least a portion containing a magnetic substance.

Embodiments will be described with reference to the drawings. Like reference numerals in the drawings denote like elements, and the descriptions of the like elements are appropriately omitted and the different elements are described.

### First Embodiment

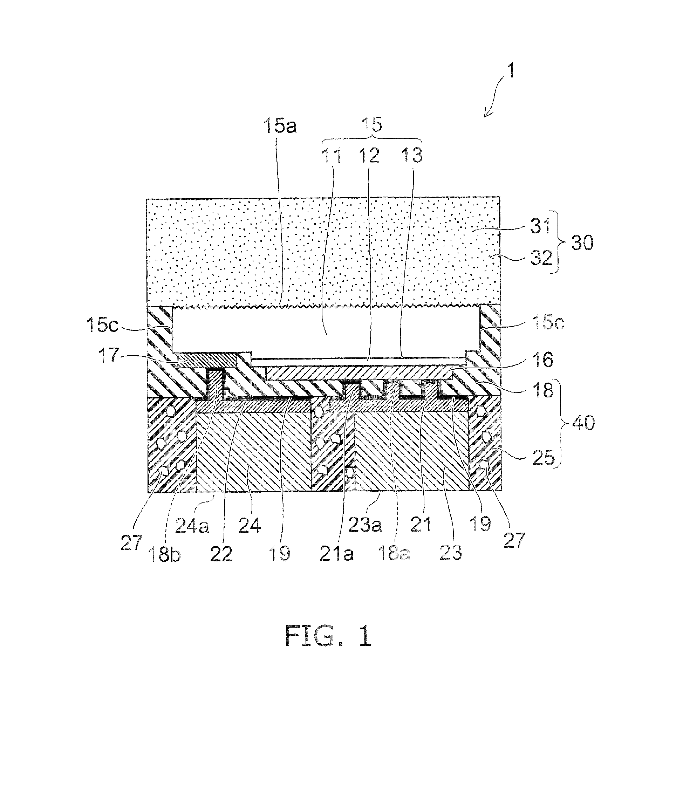

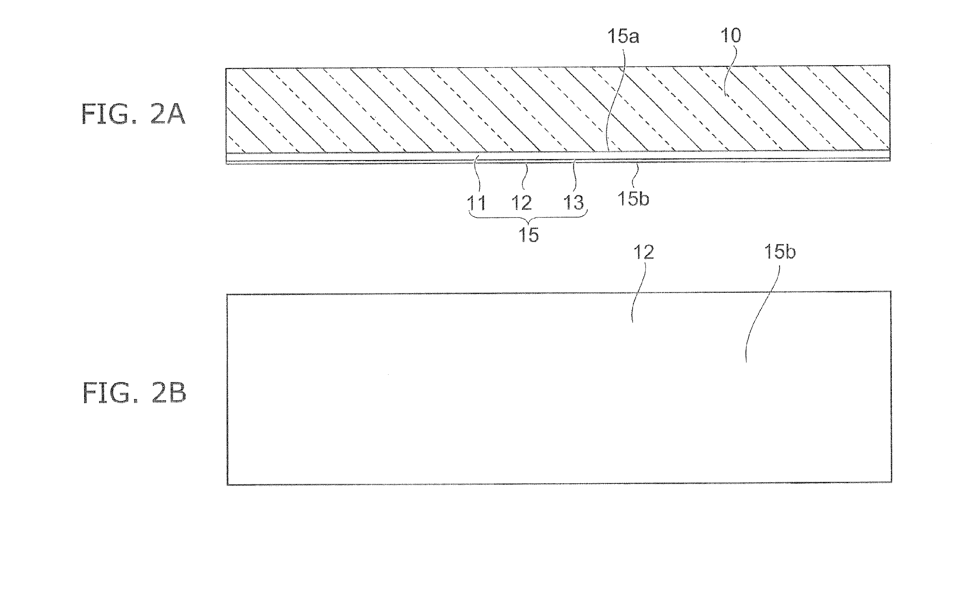

FIG. 1 is a schematic cross-sectional view of a semiconductor light emitting device 1 according to a first embodiment. The semiconductor light emitting device 1 includes a semiconductor layer 15 having a light emitting layer 13. The semiconductor layer 15 includes a first face 15a and a second face 15b opposite to the first face 15a (see FIG. 2A), and electrodes and interconnections are provided on the second face side. The semiconductor layer 15 emits light outward from the light emitting layer 13 through the first face 15a.

The semiconductor light emitting device 1 further includes a fluorescent substance layer 30 provided on the first face 15a and an insulating layer 40 provided on the second face 15b side.

The fluorescent substance layer 30 includes a transparent resin 31 through which light emitted from the light emitting layer 13 is transmitted and a fluorescent substance 32 dispersed in the transparent resin. The fluorescent substance 32 is excited by the light emitted from the light emitting layer 13, and emits light at a wavelength different from the wavelength of pumping light.

It is noted that "being transparent" referred here is not limited to transmitting all the light emitted from the light emitting layer 13. The transparent resin 31 may partially absorb light emitted from the light emitting layer 13.

The insulating layer 40 covers the semiconductor layer 15, the electrodes, and the interconnection layers, and includes at least a portion containing a magnetic substance 27.

In the embodiment, the insulating layer 40 includes an insulating film 18 and a resin (in the following, referred to as a sealing resin 25) provided on the insulating film 18. The sealing resin 25 contains the magnetic substance 27.

The magnetic substance 27 has a shape of fine particle, for example, and includes iron (Fe), ferrite, rare earth neodymium (Nd-Fe-B), or the like.

Here, the term "Covering" is not limited to the case where a component covering an element directly contacts the element. "Covering" also includes the case where a component covering an element contacts a different component that covers the element.

In the following, the structure of the semiconductor light emitting device 1 will be described in detail with reference to FIG. 1.

The semiconductor layer 15 includes a first semiconductor layer 11 and a second semiconductor layer 12. The first semiconductor layer 11 and the second semiconductor layer 12, for example, contain gallium nitride. The first semiconductor layer 11 may include an underlying buffer layer, an n-type GaN layer, and the like. The second semiconductor layer 12 includes a p-type GaN layer, a light emitting layer (active layer) 13, and the like. The light emitting layer 13 may include a material that emits blue light, purple light, blue-purple light, ultraviolet light, or the like.

As shown in FIG. 1, the semiconductor layer 15 has a region including the light emitting layer 13 and a region not including the light emitting layer 13. The area of the region including the light emitting layer 13 is provided wider than the area of the region not including the light emitting layer 13.

Namely, the second face of the semiconductor layer 15 is processed in a concavity and convexity shape. The convexity portion includes the light emitting layer 13, and a p-side electrode 16 is provided on the surface of the second semiconductor layer 12, which is the surface of the. In other words, the p-side electrode 16 is provided in the region including the light emitting layer 13 on the second face side.

On the second face of the semiconductor layer 15, the region not including the light emitting layer 13 is provided side by side with the convexity portion. An n-side electrode 17 is provided on the first semiconductor layer 11 in the region not including the light emitting layer 13. Namely, the n-side electrode 17 is provided in the region not including the light emitting layer 13 on the second face side.

An insulating film 18 is provided on the second face side of the semiconductor layer 15. The insulating film 18 covers the semiconductor layer 15, the p-side electrode 16, and the n-side electrode 17. In addition, the insulating film 18 covers the side surfaces of the light emitting layer 13 and the second semiconductor layer 12 for the protection thereof.

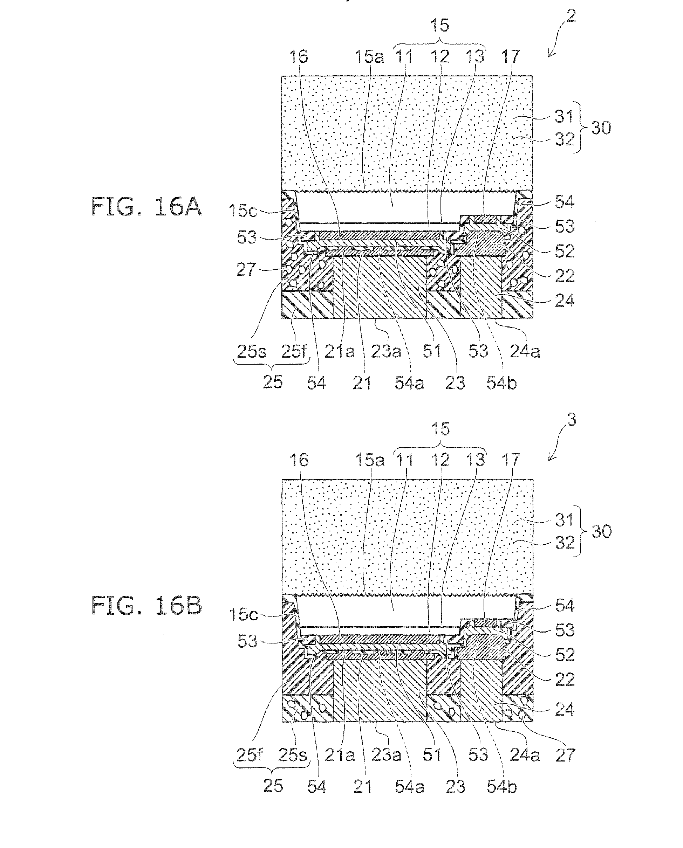

In addition, another insulating film (for example, a silicon oxide film) may be provided between the insulating film 18 and the semiconductor layer 15. The insulating film 18, for example, is formed of a resin such as polyimide that is superior for the patterning of fine openings. Alternatively, an inorganic film such as a silicon oxide film or a silicon nitride film may be used as the material of the insulating film 18 (for example, the insulating film 54 shown in FIG. 16). The insulating film 18 covers a side face 15c contacting the first face 15a at a corner, and not provided on the first face 15a.

A p-side interconnection layer 21 and an n-side interconnection layer 22 are provided on a face of the insulating film 18 opposite to the second face of the semiconductor layer 15, so as to be separated from each other.

Parts of the p-side interconnection layer 21 are provided in a plurality of first openings 18a that are formed in the insulating film 18 up to the p-side electrodes 16, and the p-side interconnection layer 21 is electrically connected to the p-side electrodes 16. A part of the n-side interconnection layer 22 is also provided in a second opening 18b that is formed in the insulating film 18 up to the n-side electrodes 17, and the n-side interconnection layer 22 is electrically connected to the n-side electrodes 17.

A p-side metal pillar 23 is provided on a face of the p-side interconnection layer 21 opposite to the p-side electrode 16. Then, a p-side interconnection includes the p-side interconnection layer 21, the p-side metal pillar 23, and a metal film 19 that serves as a seed layer to be described later.

An n-side metal pillar 24 is provided on a face of the n-side interconnection layer 22 opposite to the n-side electrodes 17. Then, an n-side interconnection includes the n-side interconnection layer 22, the n-side metal pillar 24, and the metal film 19 that is used as the seed layer.

A insulating film 25 serving as a second insulating film is stacked on the insulating film 18. The insulating film 25 covers the periphery of the p-side interconnection and the periphery of the n-side interconnection. In addition, the insulating film 25 is filled up between the p-side metal pillar 23 and the n-side metal pillar 24. The side surfaces of the p-side metal pillar 23 and the n-side metal pillar 24 are covered with the insulating film 25.

A face of the p-side metal pillar 23 opposite to the p-side interconnection layer 21 is exposed from the insulating film 25 and serves as a p-side external terminal 23a. A face of the n-side metal pillar 24 opposite to the n-side interconnection layer 22 is exposed from the insulating film 25 and serves as an n-side external terminal 24a. The p-side external terminal 23a and the n-side external terminal 24a are bonded to a pad formed in a mounting substrate through a bonding member such as a solder, other metal, a material having conductivity, or the like.

A distance between the p-side external terminal 23a and the n-side external terminal 24a is longer than a distance between the p-side interconnection layer 21 and the n-side interconnection layer 22 on the insulating film 18. The p-side external terminal 23a and the n-side external terminal 24a are separated from each other with such a distance, so that the external terminals do not form a short circuit via solder or the like at the time of being mounted on the mounting substrate.

On the other hand, the p-side interconnection layer 21 may approach the n-side interconnection layer 22 up to a process limit, and accordingly, the area of the p-side interconnection layer 21 may be widened. Thereby, the contact area can be enlarged between the p-side interconnection layer 21 and the p-side electrode 16. It becomes possible to reduce a current density in the p-side interconnection, and to improve the heat dissipation.

Furthermore, the area of the p-side interconnection layer 21 that is in contact with the p-side electrodes 16 through the plurality of first openings 18a is possible to be larger than the area of the n-side interconnection layer 22 that is in contact with the n-side electrodes 17 through the second openings 18b. Thereby, the current injected into the light emitting layer can be reduced, and the current distribution in the light emitting layer 13 becomes uniform. In addition, the heat dissipation from the light emitting layer 13 through the p-side interconnection can be improved.

According to the embodiment, a high optical output can be acquired, since the light emitting layer 13 is formed over the first region that is larger than the second region on which the n-side electrode 17 is provided. In addition, the n-side interconnection layer 22 having a larger area than the n-side electrode 17 can be provided on the mounting face side. In the n-side interconnection layer 22, the portion extending on the insulating film 18 can be formed to have larger area than the contact portion that is in contact with the n-side electrodes 17.

The first semiconductor layer 11 is electrically connected to the n-side metal pillar 24 having the n-side external terminal 24a through the n-side electrode 17, the metal film 19, and the n-side interconnection layer 22. The second semiconductor layer 12 including the light emitting layer 13 is electrically connected to the p-side metal pillar 23 having the p-side external terminal 23a through the p-side electrode 16, the metal film 19, and the p-side interconnection layer 21.

The p-side metal pillar 23 is thicker than the p-side interconnection layer 21, and the n-side metal pillar 24 is thicker than the n-side interconnection layer 22. Each thickness of the p-side metal pillar 23, the n-side metal pillar 24, and the insulating film 25 is larger than that of the semiconductor layer 15. Here, the thickness represents a thickness in the vertical direction in FIG. 1.

In addition, each thickness of the p-side metal pillar 23 and the n-side metal pillar 24 is larger than that of a stacked body that includes the semiconductor layer 15, the p-side electrode 16, the n-side electrode 17, and the insulating film 18. In addition, the aspect ratio (the ratio of the thickness to the planar size) of each one of the metal pillars 23 and 24 is not limited to be one or more, and the ratio may be less than one. In other words, each thickness of the metal pillars 23 and 24 may be smaller than the planar size of the metal pillars 23 and 24.

According to the embodiment, even though a substrate 10 used for forming the semiconductor layer 15 is removed as described later, the mechanical strength of the semiconductor light emitting device 100 can be maintained, since the semiconductor layer 15 is stably supported by the p-side metal pillar 23, the n-side metal pillar 24, and the insulating film 25 .

Copper, gold, nickel, silver, and the like can be used as the materials of the p-side interconnection layer 21, the n-side interconnection layer 22, the p-side metal pillar 23, and the n-side metal pillar 24. Among these materials, copper is superior to the other material in thermal conductivity, resistance for migration, and adhesiveness to an insulating material.

The insulating film 25 reinforces the p-side metal pillar 23 and the n-side metal pillar 24. It is preferable that the thermal expansion coefficient of the insulating film 25 is the same as or close to the thermal expansion coefficient of the mounting substrate. As examples of such an insulating film 25, there are an epoxy resin, a silicone resin, a fluorine resin, and the like.

In addition, when the semiconductor light emitting device 100 is mounted on the mounting substrate through the p-side external terminal 23a and the n-side external terminal 24a, the stress applied to the semiconductor layer 15 through soldering or the like can be absorbed and relieved by the p-side metal pillar 23 and the n-side metal pillar 24.

The p-side interconnection that includes the p-side interconnection layer 21 and the p-side metal pillar 23 is connected to the p-side electrode 16 through a plurality of vias 21a that are provided inside the plurality of first openings 18a and are separated from each other. Accordingly, an effective stress relieving can be obtained through the p-side interconnection.

Alternatively, the p-side interconnection layer 21 may be connected to the p-side electrode 16 through a post that has a planar size larger than the via 21a. In such a case, the heat dissipation of the light emitting layer 13 can be improved through the p-side electrode 16, the p-side interconnection layer 21, and the p-side metal pillar 23, all of which are formed of metal.

As described later, the substrate 10 used for a crystal growth of the semiconductor layer 15 is removed from the first face 15a. Accordingly, the height of the semiconductor light emitting device 100 can be lowered.

A fine concavo-convex is formed on the first face 15a of the semiconductor layer 15 using wet etching (frost process), where an alkali-based solution is applied to the first face 15a. The light emitted from the light emitting layer 13 can be extracted outside through the first face 15a, suppressing light reflection at various incident angles by providing the concavo-convex on the first face 15a.

A fluorescent substance layer 30 is provided on the first face 15a. The fluorescent substance layer 30 includes a transparent resin 31 and a plurality of fluorescent substances 32 dispersed in the transparent resin 31. The transparent resin 31 has transparency for the lights emitted from the light emitting layer 13 and the fluorescent substance 32. For example, a silicone resin, an acrylic resin, a phenyl resin, or the like may be used as the transparent resin 31. The fluorescent substance 32 absorbs light (pumping light) emitted from the light emitting layer 13, and emits wavelength converted light. The semiconductor light emitting device 1 emits the mixed light that includes the light emitted from the light emitting layer 13 and the wavelength converted light emitted from the fluorescent substance 32.

When the fluorescent substance 32 is a yellow fluorescent substance that emits yellow light, the mixing light of white color or warm white color, for example, can be obtained by mixing blue light emitted from the light emitting layer 13, which includes a GaN material, and yellow light, which is the wavelength converted light emitted from the fluorescent substance 32. It is noted that the fluorescent substance layer 30 may include a plurality of types of fluorescent substances (a red fluorescent substance to emit red light and a green fluorescent substance to emit green light, for example).

Next, a method of manufacturing the semiconductor light emitting device 1 according to the embodiment will be described with reference to FIGS. 2A to 15B. FIGS. 2A to 13B show partial areas of a wafer.

FIG. 2A is a schematic cross-sectional view of the semiconductor layer 15. The semiconductor layer 15 is a stacked body in which a first semiconductor layer 11 and a second semiconductor layer 12 are formed on a major face (the lower face in FIG. 2A) of a substrate 10. FIG. 2B is a schematic view corresponding to a lower face in FIG. 2A.

The first semiconductor layer 11 is formed on the major face of the substrate 10, and the second semiconductor layer 12 including a light emitting layer 13 is formed thereon. For example, the first semiconductor layer 11 and the second semiconductor layer 12 may contain gallium nitride, and grown on a sapphire substrate by using a metal organic chemical vapor deposition (MOCVD) method. Alternatively, a silicon substrate may be used as the substrate 10.

A first face 15a of the semiconductor layer 15 is a face through which the first semiconductor layer 11 is in contact with the substrate 10, and a second face 15b of the semiconductor layer 15 is the surface of the second semiconductor layer 12 opposite to the first semiconductor layer 11, as shown in FIG. 2.

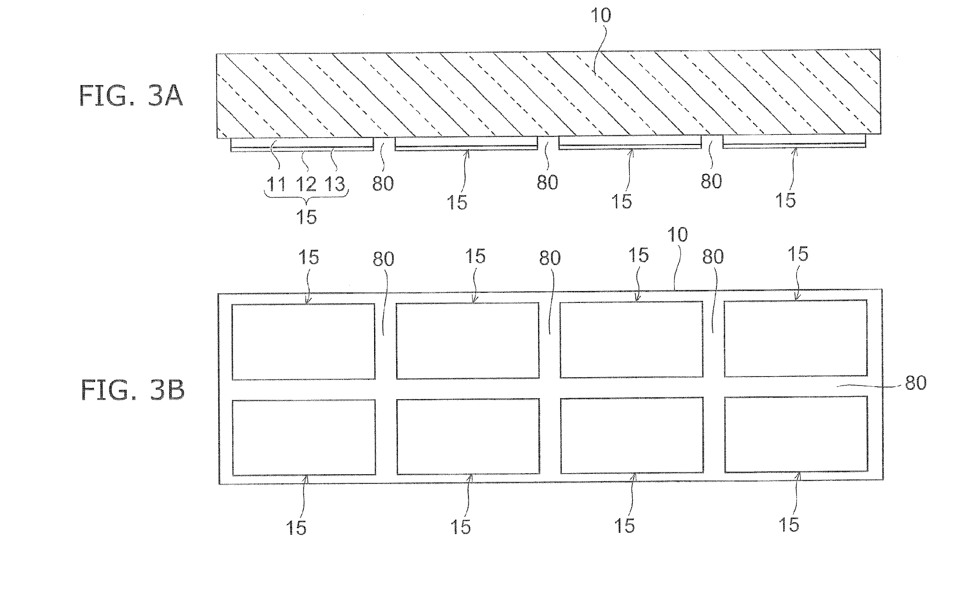

Next, as shown in FIG. 3A, a groove 80 is formed passing through the semiconductor layer 15 and reaching the substrate 10, for example, by using a reactive ion etching (RIE) method using a resist mask (not shown). As shown FIG. 3B corresponding to the lower face of FIG. 3A, the groove 80 is formed, for example, in a lattice pattern on the substrate 10, and separates the semiconductor layer 15 into a plurality of chips on the substrate 10.

Alternatively, the process for separating the semiconductor layer 15 into multiple parts may be performed after selectively removing the second semiconductor layer 12, or after forming the p-side electrode 16 and the n-side electrode.

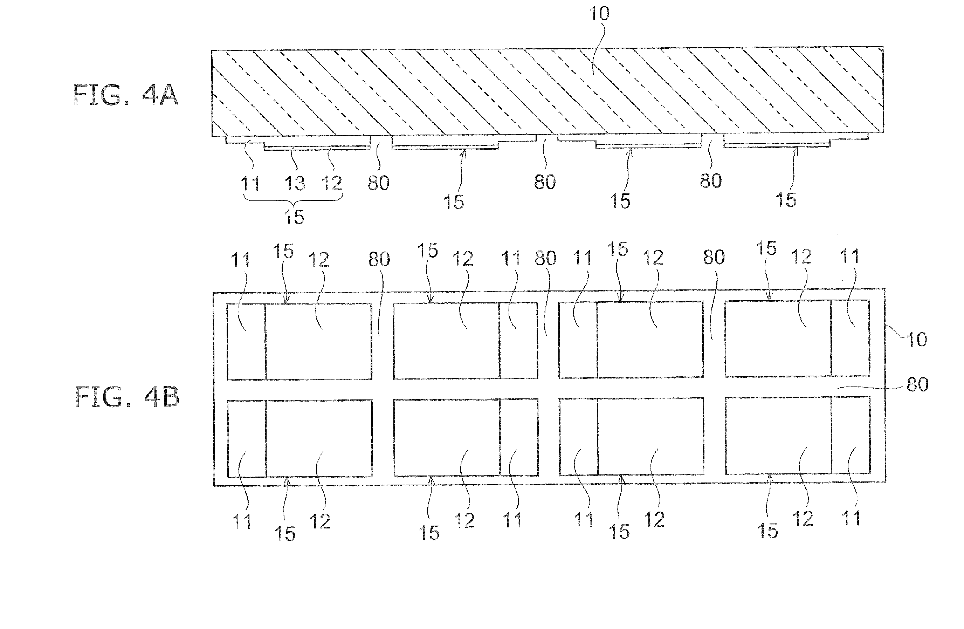

Next, as shown in FIG. 4A and FIG. 4B corresponding to the lower face of FIG. 4A, parts of the second semiconductor layer 12 are removed so as to expose parts of the first semiconductor layer 11, for example, by using the RIE method using a resist mask (not shown).

Each region in which the first semiconductor layer 11 is exposed does not include the light emitting layer 13 as shown in FIG. 4A. An area of the second semiconductor layer 12 that includes the light emitting layer 13 is wider than an area of the region not including the light emitting layer 13, where the first semiconductor layer 11 is exposed, as shown in FIG. 4B.

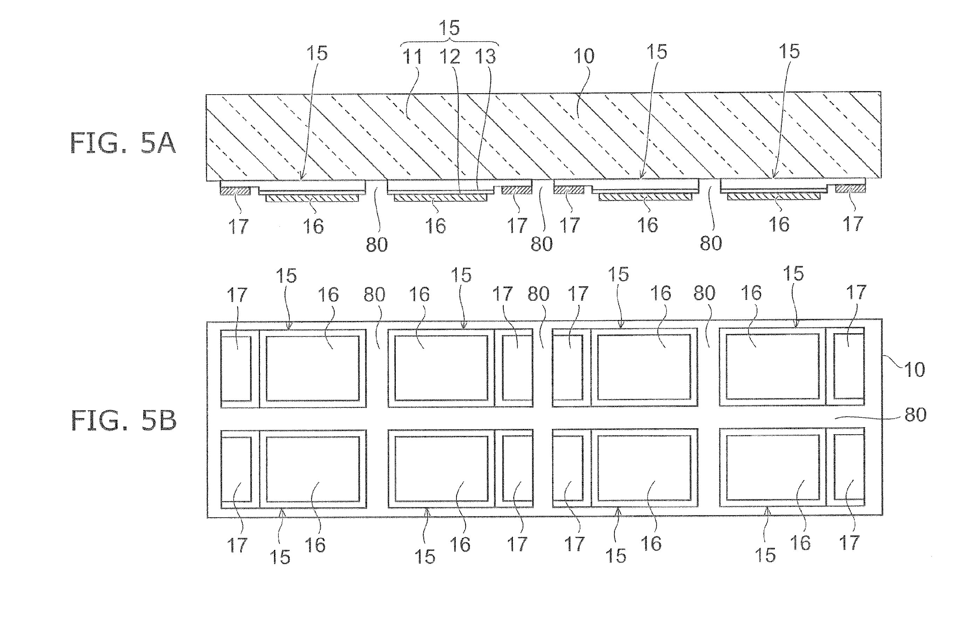

Next, as shown in FIG. 5A and FIG. 5B corresponding to the lower face of FIG. 5A, p-side electrodes 16 and n-side electrodes 17 are formed on the second face of the semiconductor layer 15. The p-side electrodes 16 are formed on the surfaces of the second semiconductor layer 12. The n-side electrodes 17 are formed on the exposed surfaces of the first semiconductor layer 11.

The p-side electrodes 16 and the n-side electrodes 17, for example, are formed using a sputtering method, a vapor deposition method, or the like. Either the p-side electrodes 16 or the n-side electrodes 17 may be formed first, or the p-side electrode 16 and n-side electrodes 17 may be simultaneously formed and inevitably made of the same material.

The p-side electrode 16 has preferably formed so as to reflect the light emitted from the light emitting layer 13. Hence, the p-side electrode 16 may include silver, silver alloy, aluminum, aluminum alloy, and the like. In addition, the p-side electrode 16 may include a metal protective film (barrier metal) formed on the reflection electrode, in order to prevent the reflection electrode from the sulfurization and the oxidization.

The area of the p-side electrode 16 provided in the region including the light emitting layer 13 is wider than the area of the n-side electrode 17 provided in the region not including the light emitting layer 13, so that a wide light emitting region can be obtained. It is noted that the layout of the p-side electrodes 16 and the n-side electrodes 17 shown in FIG. 5B is an example, and the layout is not limited to the layout shown in FIG. 5B.

In addition, a silicon nitride film or a silicon oxide film may be formed as a passivation film by using a chemical vapor deposition (CVD) method between the p-side electrode 16 and the n-side electrode 17 or on the end face (side surface) of the light emitting layer 13. In addition, activated annealing may be performed as necessary for forming an ohmic contact between each electrode and the semiconductor layer.

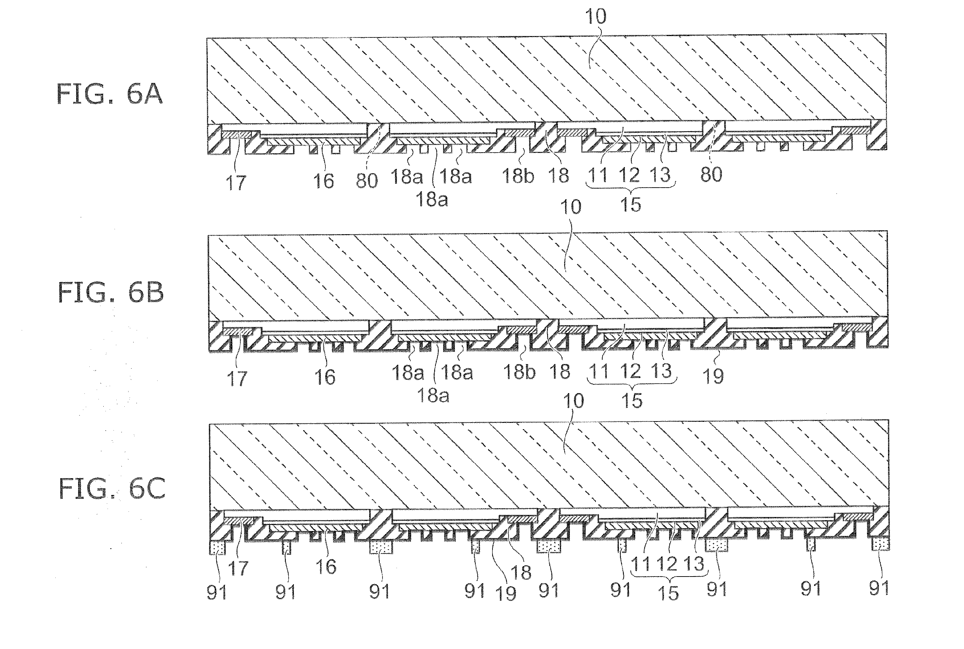

Next, after all the parts formed on the major face of the substrate 10 are covered with an insulating film 18 shown in FIG. 6A, and the insulating film 18 is patterned, for example, by using wet etching, whereby first openings 18a and a second opening 18b are selectively formed in the insulating film 18. A plurality of the first openings 18a are formed in the insulating film 18, and each of the first openings 18a reaches the p-side electrodes 16. The second opening 18b also reaches the n-side electrode 17.

For example, an organic material such as a photosensitive polyimide or benzocyclobutene can be used as the material of the insulating film 18. In such a case, the insulating film 18 can be directly exposed and developed using photo-lithography, and the first and second openings 18a, 18b are directly formed therein without using a resist mask.

Alternatively, an inorganic film such as a silicon nitride film or a silicon oxide film may be used as the insulating film 18. In a case where the insulating film 18 is an inorganic film, the first openings 18a and the second opening 18b are formed using selective etching using a resist mask formed on the insulating film 18.

Next, as shown in FIG. 6B, a metal film 19 is formed on the surface of the insulating film 18, the inner walls (the side wall and the bottom portion) of the first opening 18a, and the inner wall (the side wall and the bottom portion) of the second opening 18b. The metal film 19 is used as a seed metal for plating, which will be described later.

The metal film 19, for example, is formed using a sputtering method. The metal film 19 includes a stacked film, for example, in which a titanium (Ti) layer and a copper (Cu) layer are stacked in order from the insulating film 18 side. Alternatively, an aluminum layer may be used instead of the titanium layer.

Next, as shown in FIG. 6C, resists 91 are selectively formed on the metal film 19, and Cu electroplating is performed using the metal film 19 as a current path.

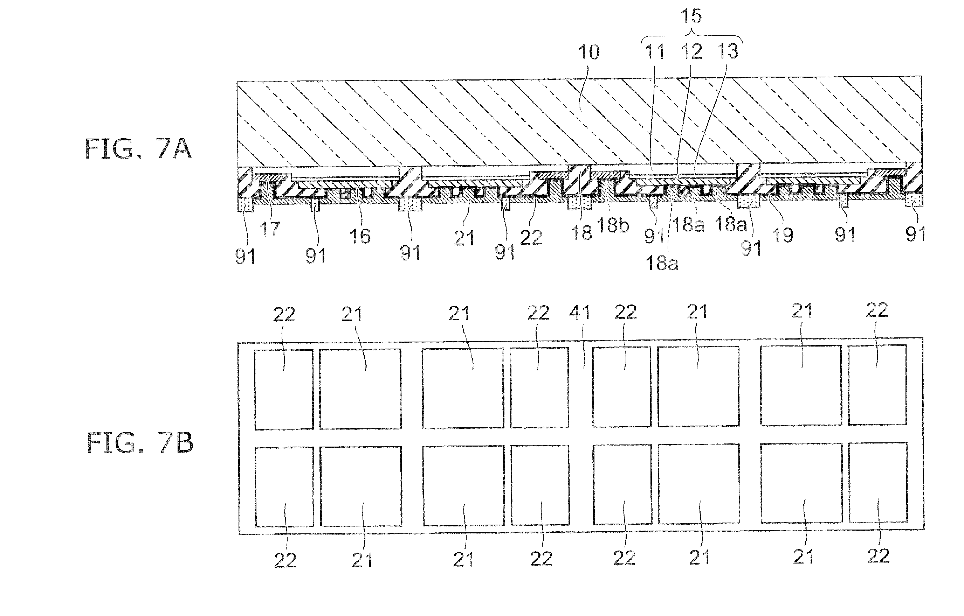

Accordingly, as shown in FIG. 7A and FIG. 7B corresponding to the lower face of FIG. 7A, a p-side interconnection layer 21 and an n-side interconnection layer 22 are selectively formed on the metal film 19. The p-side interconnection layer 21 and the n-side interconnection layer 22 are simultaneously formed, for example, by using copper plating.

The p-side interconnection layer 21 is also formed inside the first openings 18a and is electrically connected to the p-side electrode 16 via the metal film 19. In addition, the n-side interconnection layer 22 is formed also inside the second openings 18b and is electrically connected to the n-side electrodes 17 via the metal film 19.

The resists 91 that are used for plating the p-side interconnection layer 21 and the n-side interconnection layer 22 are removed using solvent or oxygen plasma.

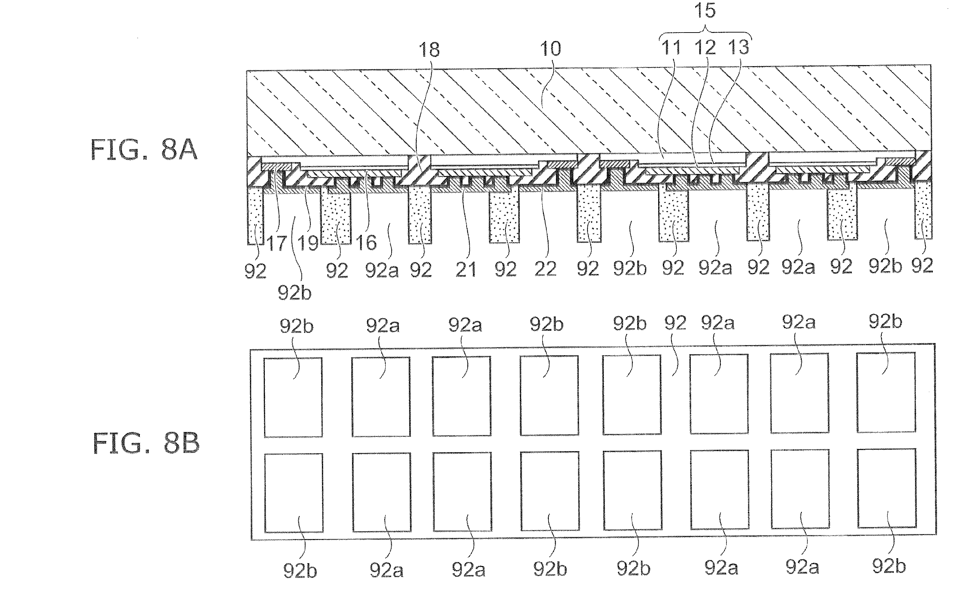

Next, as shown in FIG. 8A and FIG. 8B corresponding to the lower face of FIG. 8A, resists 92 are formed for forming metal pillars. The resist 92 is thicker than the above-described resist 91. It may be possible to leave the resists 91 without removing in the previous process, and the resists 92 are formed so as to overlap the resists 91. First openings 92a and second openings 92b are formed in the resists 92.

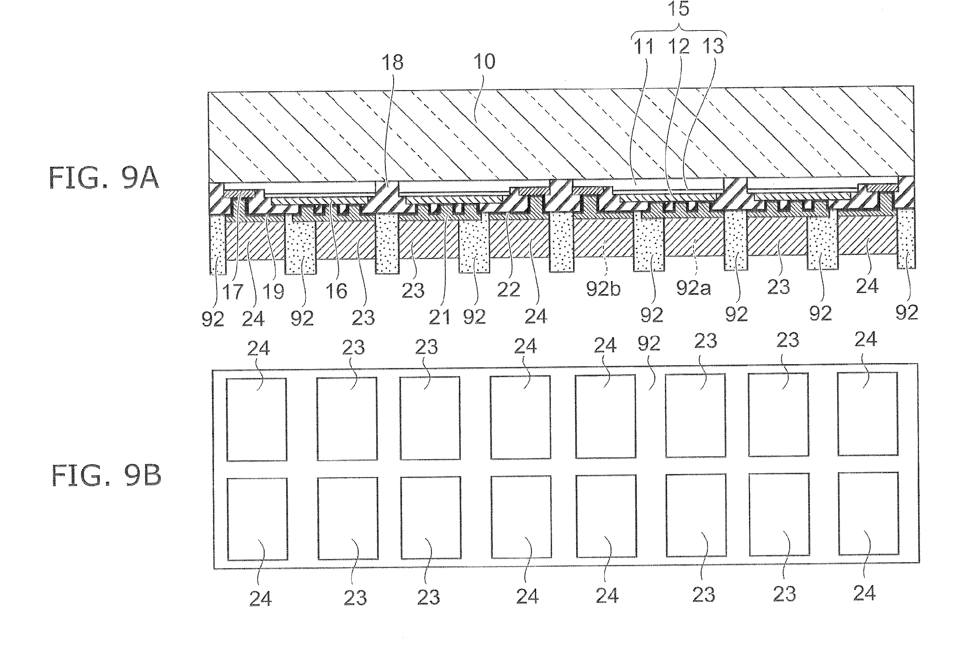

Then, Cu electroplating is performed using the metal film 19 as a current path and the resists 92 as a mask. Accordingly, as shown in FIG. 9A and FIG. 9B corresponding to the lower face of FIG. 9A, a p-side metal pillar 23 and an n-side metal pillar 24 are formed on the p-side interconnection layer 21 and n-side interconnection layer 22 respectively.

The p-side metal pillar 23 is formed on the p-side interconnection layer 21 inside the first opening 92a that is formed in the resist 92. The n-side metal pillar 24 is formed on the n-side interconnection layer 22 inside the second opening 92b that is formed in the resist 92. The p-side metal pillar 23 and the n-side metal pillar 24 are simultaneously formed using copper plating, for example.

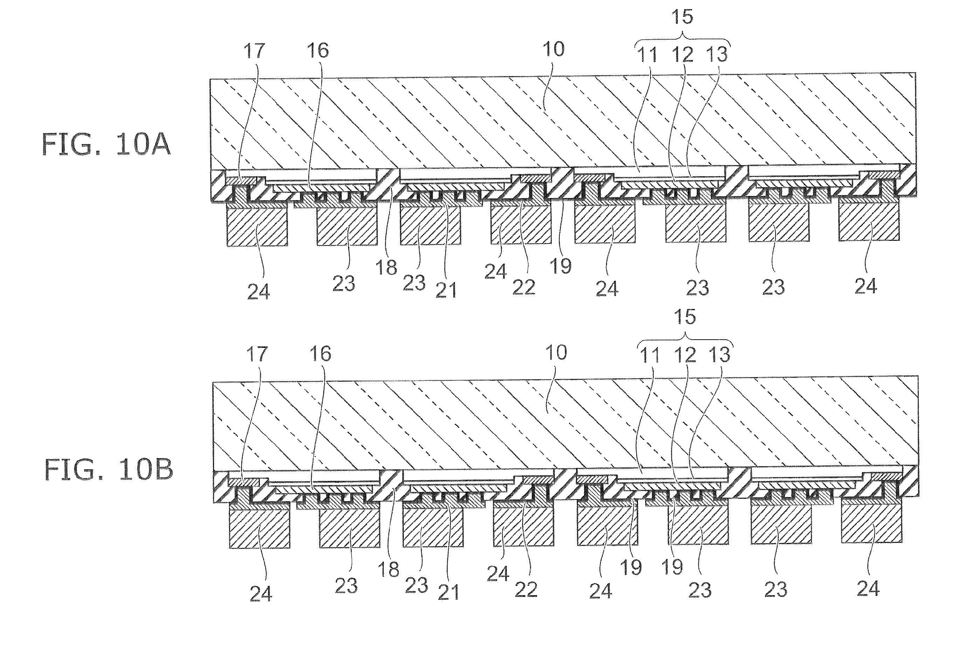

The resist 92, as shown in FIG. 10A is removed, for example, by using solvent or oxygen plasma. Thereafter, exposed parts of the metal film 19 are removed by wet etching while using the p-side metal pillar 23, the n-side metal pillar 24, the p-side interconnection layer 21, and the n-side interconnection layer 22 as a mask. Accordingly, as shown in FIG. 10B, the p-side interconnection layer 21 and the n-side interconnection layer 22 is separated from each other on the insulating film 18, cutting off the electric connection therebetween.

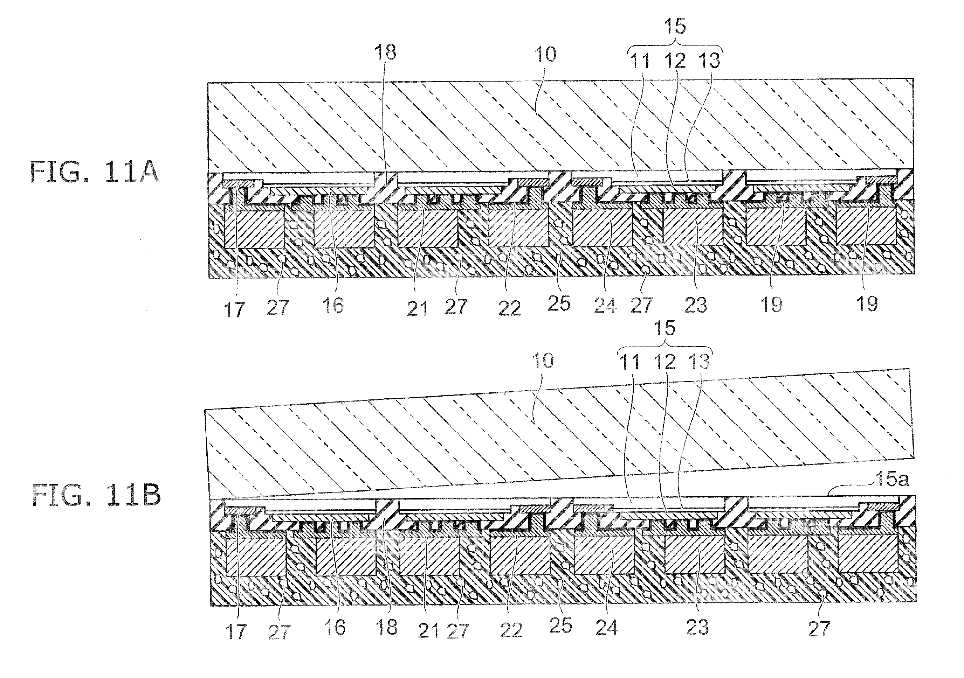

Next, as shown in FIG. 11A, an insulating film 25 is stacked on the insulating film 18. The insulating film 25 covers the p-side interconnection layer 21, the n-side interconnection layer 22, the p-side metal pillar 23, and the n-side metal pillar 24. The magnetic substance 27 is dispersed in the sealing resin 25.

The magnetic substance 27 has a shape of fine particle, for example, and includes iron (Fe), ferrite, rare earth neodymium (Nd-Fe-B), or the like, and the magnetic substance 27 is added so as not to impair the insulating characteristics of the sealing resin 25. Namely, the particle diameter of the magnetic substance 27 is the minimum distance between the p-side metal pillar 23 and the n-side metal pillar 24 or less. The magnetic substance 27 is dispersed in such a way that the magnetic substances 27 does not contacts each other and not form a current path between the p-side metal pillar 23 and the n-side metal pillar 24, for example. That is, the sealing resin insulates the p-side interconnection from the n-side interconnection.

In addition, for example, carbon black may be dispersed in the insulating film 25 so as to shield the light emitted from the light emitting layer 13.

Next, the substrate 10 is removed as shown in FIG. 11B. In a case where the substrate 10 is a sapphire substrate, the substrate 10 can be removed, for example, using a laser lift-off method. Specifically, laser light is radiated from the backside of the substrate 10 toward the first semiconductor layer 11. The laser light has transparency for the substrate 10 and has a wavelength in an absorption band of the first semiconductor layer 11.

When the laser light arrives at an interface between the substrate 10 and the first semiconductor layer 11, part of the first semiconductor layer 11 that is located near the interface absorbs energy of the laser light and decomposes. The first semiconductor layer 11 is decomposed into gallium (Ga) and nitrogen gas. According to the decomposition reaction, a minute gap is formed between the substrate 10 and the first semiconductor layer 11, whereby the substrate 10 and the first semiconductor layer 11 are separated from each other.

In a case where the substrate 10 is a silicon substrate, the substrate 10 can be removed by etching from the first semiconductor layer 11.

The semiconductor layer 15 is reinforced by the p-side metal pillar 23, the n-side metal pillar 24, and the insulating film 25 , and accordingly, the wafer shape can be maintained even after the substrate 10 is removed therefrom.

Strong internal stress is contained between the substrate 10 and the semiconductor layer 15 during the epitaxial growth, and released at once by removing the substrate 10. According to the embodiment, the insulating film 25, and the metal that configures the p-side metal pillar 23 and the n-side metal pillar 24 are more flexible than the material of the semiconductor layer 15. That is, the semiconductor layer 15 is supported by the flexible support members. Accordingly, the released stress may be absorbed by the insulating film 25 , the p-side metal pillar 23 and the n-side metal pillar 24, preventing the semiconductor layer 15 from being destroyed.

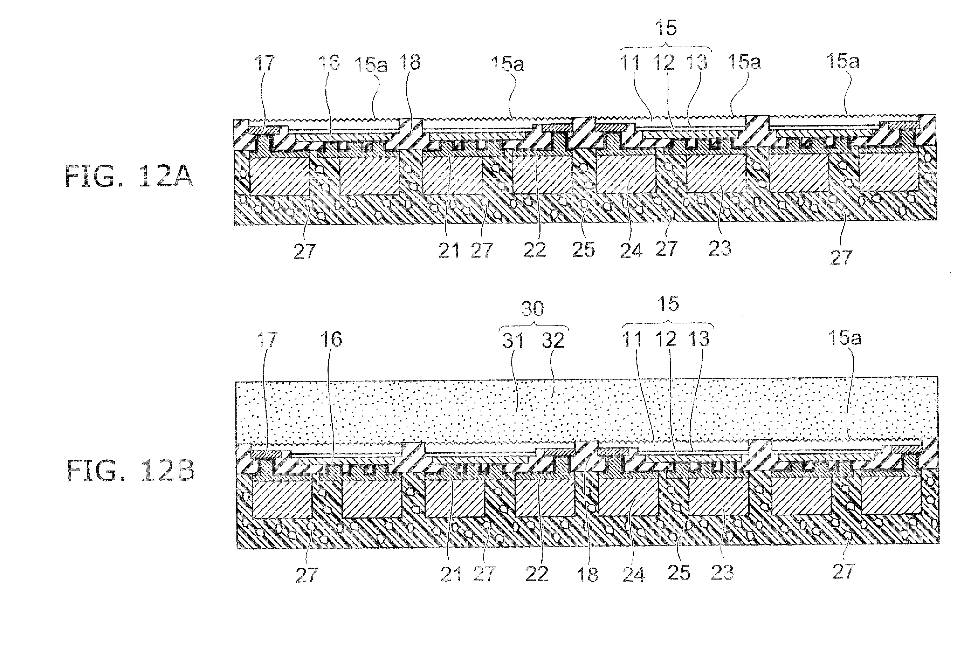

The first face 15a of the semiconductor layer 15 is cleaned after removing the substrate 10 therefrom. For example, gallium (Ga) that is stuck to the first face 15a is removed by using rare hydrofluoric acid or the like. Thereafter, wet etching is performed for the first face 15a, for example, by using a potassium hydroxide (KOH) solution, tetramethylammonium hydroxide (TMAH), or the like. Accordingly, the concavo-convex is formed on the first face 15a due to a difference in the etching speed that depends on the direction of the crystal plane, as shown in FIG. 12A. Alternatively, the concavo-convex may be formed on the first face 15a by etching using a resist mask. The concavo-convex formed on the first face 15a may improve the light extraction efficiency.

Next, as shown in FIG. 12B, a fluorescent substance layer 30 is formed on the first face 15a. The fluorescent substance layer 30 is also formed on the insulating film 18 between semiconductor layers 15 adjacent to each other. More specifically, the transparent resin 31 is thermally cured after a transparent resin 31 of a liquid phase in which fluorescent substances 32 are dispersed is supplied to the upper side of the first face 15a, for example, using a method such as a printing method, a potting method, a molding method, or a compression molding.

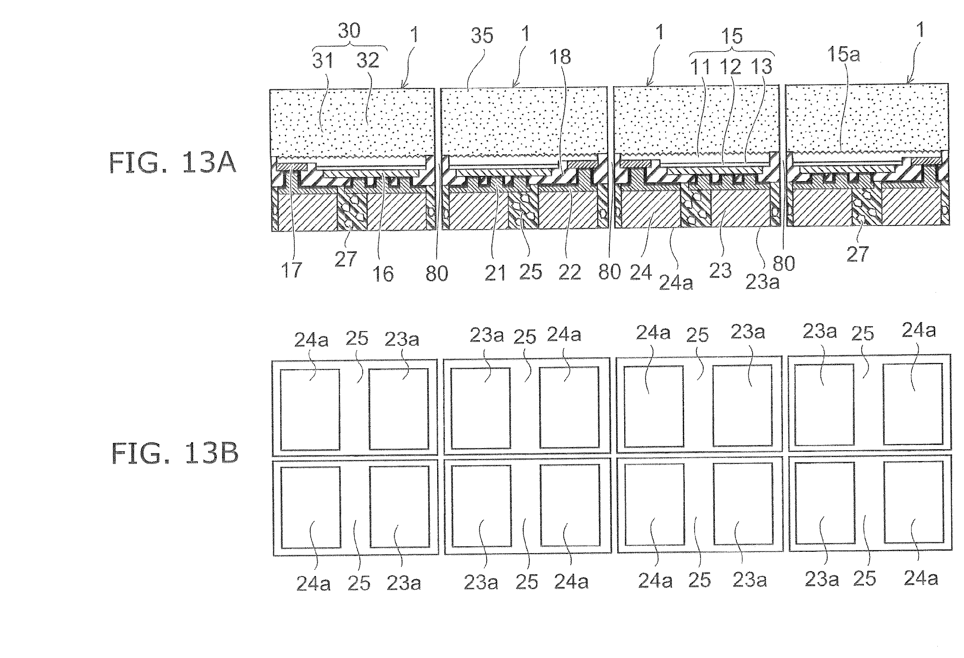

Subsequently, the surface (the lower face in FIG. 12B) of the insulating film 25 is ground such that the p-side external terminals 23a and the n-side external terminals 24a are exposed as shown in FIG. 13A and FIG. 13B corresponding to the lower face of FIG. 13A.

Thereafter, at the position of the above-described groove 80, the transparent film 35, the wafer is diced through the fluorescent substance layer 30, the insulating film 18, and the insulating film 25 so as to separate into a plurality of semiconductor light emitting devices 1. For example, the dicing is performed using a dicing blade. Alternatively, the dicing may be performed using laser radiation.

When the dicing is performed, the substrate 10 has been already removed. In addition, since the semiconductor layer 15 is also removed in the groove 80, the semiconductor layer 15 can be prevented from damage, while the dicing is performed. In addition, the end portion (side surface) of the semiconductor layer 15 is covered with the insulating film 18. Thereby, the protection of the end portion can be obtained without any additional process after dicing into the plurality of semiconductor light emitting devices 1. In addition, the semiconductor light emitting device 1 may have a single chip structure that includes one semiconductor layer 15 or a multiple-chip structure that includes a plurality of semiconductor layers 15.

Since the above-described manufacturing process before dicing are performed in the wafer state, and each diced device includes a package protecting the semiconductor 15 and the interconnection formed therein, it is possible to significantly reduce the production cost. In other words, the interconnection and the packaging are completed at the diced state. Accordingly, it is possible to improve the productivity, and to reduce the manufacturing cost.

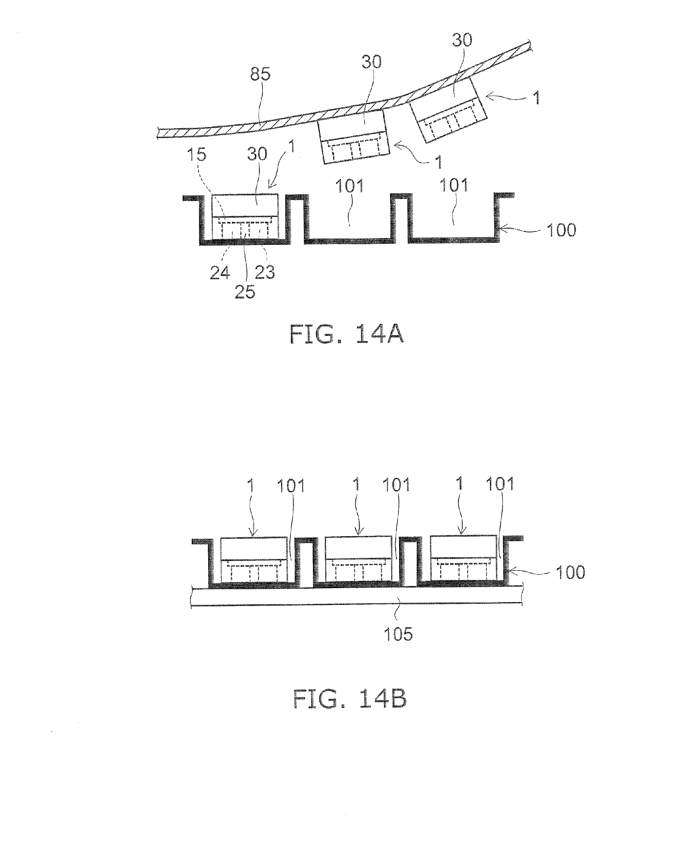

FIG. 14A and FIG. 14B are schematic views illustrating an assembling process of the semiconductor light emitting device 1. The semiconductor light emitting device 1 is accommodated in a pocket 101 of a case 100, for example, encapsulated with a cover tape 85, and then transported or sold. In the mounting processes, the cover tape 85 is removed from the case 100, and the semiconductor light emitting devices 1 accommodated in the pockets 101 are picked up, and placed at predetermined positions on the mounting substrates.

The top surface of the semiconductor light emitting device 1 is the surface of the fluorescent substance layer 30 including the transparent resin 31. Hence, the top surface has an adhesive property. Then, the semiconductor light emitting device 1 is sometimes bonded to the cover tape 85 and taken out of the pocket 101 as shown in FIG. 14A, when the cover tape 85 is removed from the case 100. In such a case, the semiconductor light emitting device 1 bonded to the cover tape 85 is removed and accommodated again in the pocket 101, before setting the case 100 on a transfer apparatus for mounting. Thereby, working efficiency is degraded due to time and effort to bring the semiconductor light emitting device 1 back to the case 100. There may be the case that the semiconductor light emitting device 1 is damaged in handling.

In the semiconductor light emitting device 1 according to the embodiment, the magnetic substance 27 is dispersed in the sealing resin 25. For example, a magnet 105 is disposed on the back surface side of the case 100 as shown in FIG. 14B, so that the semiconductor light emitting device 1 can be sucked to the bottom face of the pocket 101. With this manner, it becomes possible to prevent the semiconductor light emitting device 1 from being bonded to the cover tape 85 and being taken out of the pocket 101, when removing the cover tape 85, and thus the semiconductor light emitting device 1 can be held in the pocket 101. Thereby, the extra time and effort are omitted, and the manufacturing efficiency can be improved.

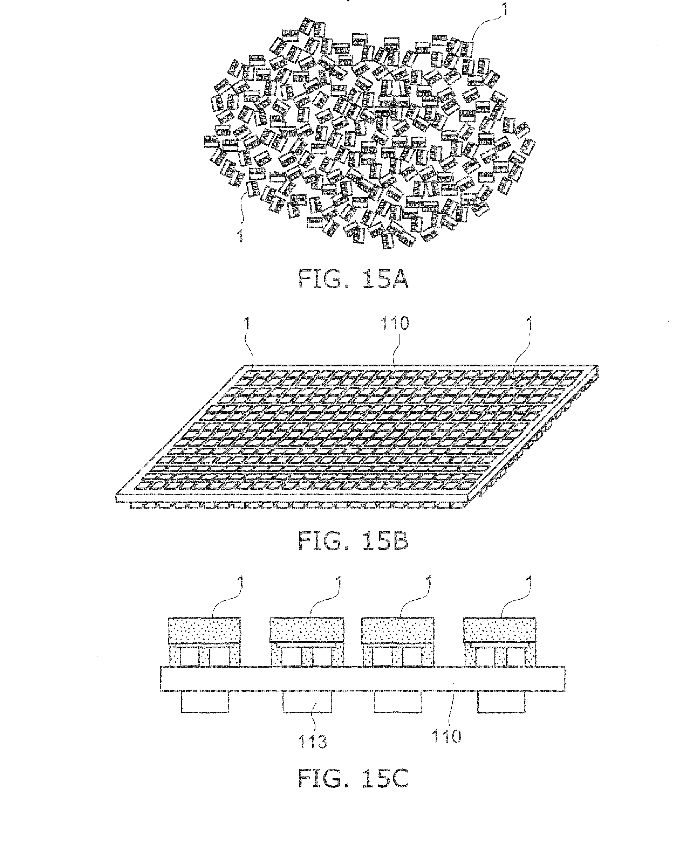

FIG. 15A to FIG. 15C are schematic views illustrating another assembling process of the semiconductor light emitting device 1 according the embodiment. For example, when picking up and mounting the semiconductor light emitting devices 1 randomly held as shown in FIG. 15A, it is preferable to take a step where the semiconductor light emitting devices 1 are temporarily arranged in a tray 110 as shown in FIG. 15B. Then, the orientations of the semiconductor light emitting devices 1 are confirmed on the tray 110, and subsequently the semiconductor light emitting devices 1 are placed on the mounting substrate, keeping the surface of the sealing resin 25, which is a mounting surface, directed downward.

In the embodiment, for example, a magnet 113 in the size smaller than the semiconductor light emitting device 1 is disposed on the back surface side of the tray 110. Thus, when the semiconductor light emitting devices 1 are moved and placed on the tray 110 from the state in FIG. 15A, the sealing resin 25 including the magnetic substance 27 is sucked to a bottom of the tray 110 due to magnetic field of the magnet 113. Hence, the semiconductor light emitting devices 1 can be arranged on the tray 110 as the surface of the sealing resin 25 is directed downward as shown in FIG. 15C. Namely, the semiconductor light emitting devices 1 can be arranged on the tray 110, so that the surface of the sealing resin 25 is directed downward. Thereby, it becomes possible to pick the semiconductor light emitting device up easily and quickly, and to improve the manufacturing efficiency can be improved.

As described above, in the embodiment, the magnetic substance 27 is dispersed in the sealing resin 25 provided on the second face 15b side of the semiconductor layer 15, whereby the semiconductor light emitting device 1 with a chip size package can be easily handled, and improve the manufacturing efficiency.

FIG. 16A is a schematic cross-sectional view of a semiconductor light emitting device 2 according to a variation of the first embodiment. The semiconductor light emitting device 2 has a sealing resin 25 including a first resin layer 25f and a second resin layer 25s. The first resin layer 25f does not contain a magnetic substance 27, and the second resin layer 25s contains the magnetic substance 27.

In the embodiment, the second resin layer 25s is provided between the first resin layer 25f and a semiconductor layer 15. Namely, the magnetic substance 27 is not dispersed in the first resin layer 25f provided on the surface side of the sealing resin 25. Thus, the first resin layer 25f may protect the second resin layer 25s including the magnetic substance 27, whereby suppressing the oxidation of the magnetic substance, for example. In addition, the wettability of solder or the like can be kept low, since the magnetic substance 27 is not exposed on the surface of the sealing resin 25. Thereby, it is possible to suppress short circuit formed between the p-side metal pillar 23 and the n-side metal pillar 24.

FIG. 16B is a schematic cross-sectional view of a semiconductor light emitting device 3 according to a variation of the first embodiment. The semiconductor light emitting device 3 has an sealing resin 25 including a first resin layer 25f not containing a magnetic substance 27 and a second resin layer 25s containing the magnetic substance 27.

In the embodiment, the first resin layer 25f is provided between the second resin layer 25s and a semiconductor layer 15. Namely, the second resin layer 25s containing the magnetic substance 27 is provided on the surface side of the sealing resin 25. The first resin layer 25f not containing the magnetic substance 27 covers the semiconductor layer 15, a p-side interconnection layer 21, and an n-side interconnection layer 22. Thus, it is possible to prevent the magnetic substance 27 from short-circuiting between the p-side interconnection layer 21 and the n-side interconnection layer 22, for example, in the case where the gap between the p-side interconnection layer 21 and the n-side interconnection layer 22 is narrow,.

As described above, the sealing resin 25 may have a stacked structure which includes a layer containing the magnetic substance and a layer not containing the magnetic substance.

It is noted that in the semiconductor light emitting devices 2 and 3 include the insulating film 54, which covers the semiconductor layer 15 instead of the insulating film 18. The insulating film 54 is an inorganic film, including a silicon oxide film or a silicon nitride film, for example. Since the insulating film 54 is formed thinner than the insulating film 18, the sealing resin 25 covers a side face 15c of the semiconductor layer 15.

A p-side pad 51 covering a p-side electrode 16 is provided on the top surface and side face of the p-side electrode 16. The p-side electrode 16 contains at least one of nickel (Ni), gold (Au), and rhodium (Rh), for example, which can form an alloy with gallium (Ga) contained in the semiconductor layer 15. The p-side pad 51 has higher reflectance to the light emitted from the light emitting layer 13 than the p-side electrode 16, since the p-side pad 51 contains silver (Ag) as a principal component, for example.

An n-side pad 52 covering an n-side electrode 17 is provided on the top surface and side face of the n-side electrode 17. The n-side electrode 17 contains at least one of nickel (Ni), gold (Au), and rhodium (Rh), for example, which can form an alloy with gallium (Ga) contained in the semiconductor layer 15. The n-side pad 52 has higher reflectance to the light emitted from the light emitting layer 13 than the n-side electrode 17, since the n-side pad 52 contains silver (Ag) as a principal component, for example.

An insulating film 53 such as a silicon oxide film and a silicon nitride film is provided on the periphery of the p-side electrode 16 and the periphery of the n-side electrode 17 on the second face side of the semiconductor layer 15, for example. The insulating film 53 is provided between the p-side electrode 16 and the n-side electrode 17 and between the p-side pad 51 and the n-side pad 52, and insulates the p-side electrode 16 from the n-side electrode 17 and the p-side pad 51 from the n-side pad 52.

The semiconductor light emitting devices 2 and 3 are applicable examples of the embodiment. For example, the sealing resin 25 of the semiconductor light emitting device 1 may be formed in a multi-layer structure. Alternatively, the above-described structure can also be applied to a side-view type semiconductor light emitting device in which the side face of the p-side metal pillar 23 and the side face of the n-side metal pillar 24 are exposed from the sealing resin 25, as described later.

As an alternative example of the embodiment, the p-side interconnection layer 21 and the n-side interconnection layer 22 may be directly bonded to the pads of the mounting substrate without providing the p-side metal pillar 23 and the n-side metal pillar 24. Furthermore, the p-side interconnection layer 21 and the p-side metal pillar 23 are not limited to be the separately formed ones, and the p-side interconnection may be provided with the p-side interconnection layer 21 and the p-side metal pillar 23, which are formed into a single body in the same process. Similarly, the n-side interconnection layer 22 and the n-side metal pillar 24 are not limited to be the separately formed ones, and the n-side interconnection may be provided with the n-side interconnection layer 22 and the n-side metal pillar 24, which is formed into a single body in the same process.

### Second Embodiment

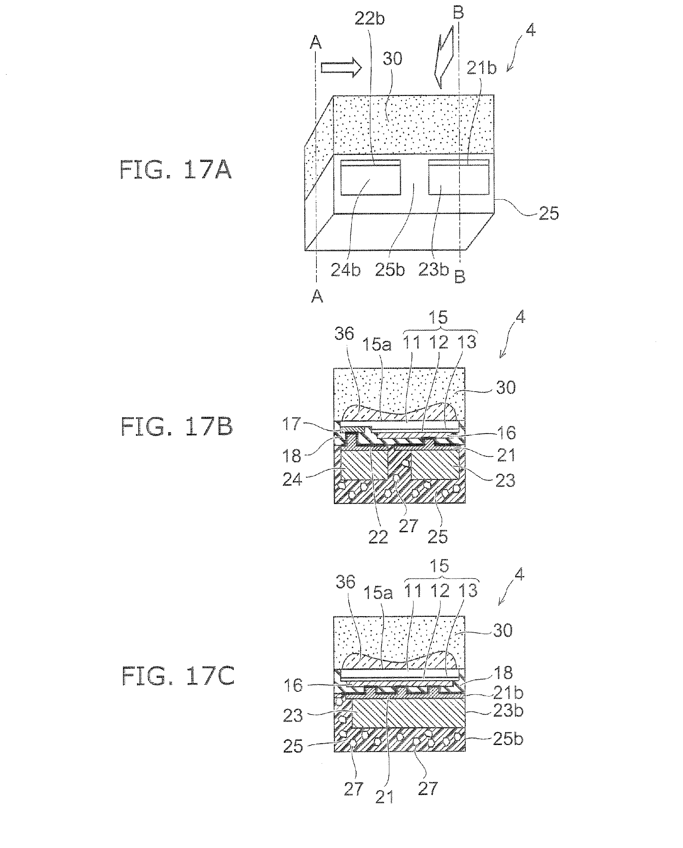

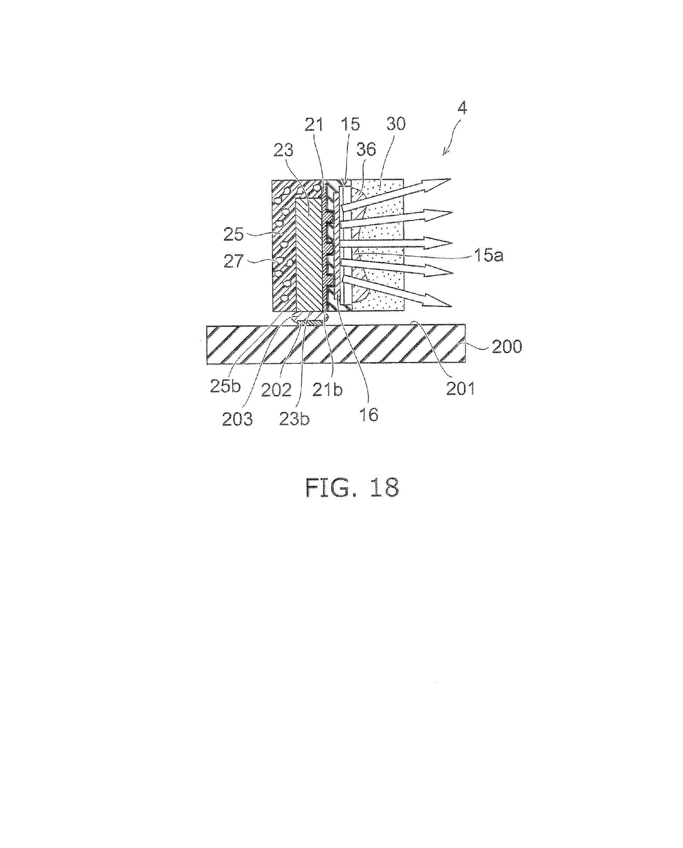

FIG. 17A is a schematic perspective view of a semiconductor light emitting device 4 according to a second embodiment. FIG. 17B is a cross-sectional view taken along line A - A shown in FIG. 17A. FIG. 17C is a cross-sectional view taken along line B - B shown in FIG. 17A. FIG. 18 is a schematic cross-sectional view of a light emitting module that has a configuration in which the semiconductor light emitting device 4 is mounted on a mounting substrate 200.

As shown in FIGS. 17A and 17C, a part of the side surface of the p-side metal pillar 23 is exposed from the insulating film 25 on a third face 25b that has a plane direction different from the first face 15a and the second face of the semiconductor layer 15. The exposed face serves as a p-side external terminal 23b for mounting the semiconductor light emitting device on an external mounting substrate.

The third face 25b is a face that is approximately perpendicular to the first face 15a and the second face of the semiconductor layer 15. The insulating film 25, for example, has four side surfaces of a rectangular shape, and one of the four side surfaces is the third face 25b.

A part of the side surface of the n-side metal pillar 24 is exposed from the insulating film 25 on the third face 25b. The exposed face serves as an n-side external terminal 24b for mounting the semiconductor light emitting device on the external mounting substrate.

In addition, as shown in FIG. 17A, a part of the side surface 21b of the p-side interconnection layer 21 is also exposed from the insulating film 25 on the third face 25b and serves as a p-side external terminal. Similarly, a part of the side surface 22b of the n-side interconnection layer 22 is also exposed from the insulating film 25 on the third face 25b and serves as an n-side external terminal.

Parts of the p-side metal pillar 23 other than the p-side external terminal 23b that is exposed on the third face 25b is covered with the insulating film 25. In addition, parts of the n-side metal pillar 24 other than the n-side external terminal 24b that is exposed on the third face 25b is covered with the insulating film 25.

In addition, parts of the p-side interconnection layer 21 other than the side surface 21b that is exposed on the third face 25b is covered with the insulating film 25. In addition, parts of the n-side interconnection layer 22 other than the side surface 22b that is exposed on the third face 25b is covered with the insulating film 25. As shown in FIG. 17A and FIG. 17B, the sealing resin 25 contains a magnetic substance 27.

On the other hand, a lens 36 is provided between the first face 15a and the fluorescent substance layer 30. The lens 36 focuses light emitted from the light emitting layer 13, and improves the light distribution. Alternatively, it may be possible not to provide the lens 36.

The semiconductor light emitting device 4, as shown in FIG. 18, is mounted in a posture in which the third face 25b faces the mounting face 201 of the mounting substrate 200. The p-side external terminal 23b and the n-side external terminal 24b that are exposed on the third face 25b are bonded to the pad 202 that is formed on the mounting face 201 through soldering 203. In addition, an interconnection pattern is formed on the mounting face 201 of the mounting substrate 200, and the pad 202 is connected to the interconnection pattern.

The third face 25b is approximately perpendicular to the first face 15a that is the major light emitting face. Accordingly, in the posture in which the third face 25b is disposed toward the lower side, i.e. facing the mounting face 201 side, the first face 15a faces in the horizontal direction, not the upper side of the mounting face 201. That is, the semiconductor light emitting device 4 is a so-called side view type device in which light is emitted in the horizontal direction in a case where the mounting face 201 is set as the horizontal plane.

In the embodiment, the semiconductor light emitting device 4 also includes the sealing resin 25 in which the magnetic substance is dispersed. Accordingly, the semiconductor light emitting device 4 can be easily handled in the mounting processes, and improve working efficiency.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A semiconductor light emitting device comprising:
a semiconductor layer (15) having a first face (15a) and a second face (15b) opposite to the first face (15a), and including a light emitting layer (13);
a p-side electrode (16) provided in a region including the light emitting layer (13) on the second face side (15b);
an n-side electrode (17) provided in a region not including the light emitting layer (13) on the second face side (15b); and
an insulating layer (40) covering the semiconductor layer (15), the p-side electrode (16), and the n-side electrode (17) on the second face side (15b), and including at least a portion containing a magnetic substance (27).

2. The device according to claim 1, further comprising a fluorescent substance layer (30) including:
a transparent resin (31) provided on the first face side, the transparent resin (31) transmitting light emitted from the light emitting layer; and
a fluorescent substance (32) dispersed in the transparent resin (31).

3. The device according to claim 1, wherein the insulating layer (40) includes a resin (25) that contains the magnetic substance (27).

4. The device according to claim 3, wherein the resin (25) insulates the p-side electrode (16) from the n-side electrode (17).

5. The device according to claim 3 or 4, wherein the resin (27) shields light emitted from the light emitting layer (13).

6. The device according to any one of claim 3 to 5, wherein the resin (25) includes a first resin layer (25f) not including the magnetic substance (27), and a second resin layer (25s) including the magnetic substance (27).

7. The device according to claim 6, wherein the first resin layer (25f) is provided between the second resin layer (25s) and the semiconductor layer (15).

8. The device according to claim 6, wherein the second resin layer (25s) is provided between the first resin layer (25f) and the semiconductor layer (15).

9. The device according to any one of claim 1 to 8, wherein the magnetic substance (27) includes at least one of ferrite and rare earth neodymium.

10. The device according to any one of claim 1 to 8, further comprising:
a p-side interconnection (21, 23) electrically connected to the p-side electrode (16), and
an n-side interconnection (22, 24) electrically connected to the n-side electrode (17),
wherein the insulating layer (40) includes an insulating film (18) on which the p-side interconnection (21, 23) and the n-side interconnection(22, 24) are provided, and the resin (25) covers the insulating film (18), the p-side interconnection (21, 23) and the n-side interconnection (22, 24).

11. The device according to claim 10, wherein the insulating film (18) covers a side face of the semiconductor layer (15), the side face (15c) contacting the first face (15a).

12. The device according to claim 10 or 11, wherein the resin (25) is provided between the p-side interconnection (21, 23) and the n-side interconnection (22, 24).

13. The device according to claim 12, wherein the resin (25) covers a periphery of the p-side interconnection (21, 23) and a periphery of the n-side interconnection (22, 24).

14. The device according to any one of claim 10 to 13, wherein
the p-side interconnection (21, 23) includes a p-side interconnection layer (21) provided on the first insulating film (18), and a p-side metal pillar (23) provided on the p-side interconnection layer (21), the p-side metal pillar (23) being thicker than the p-side interconnection layer (21); and
the n-side interconnection (22, 24) includes an n-side interconnection layer (22) provided on the first insulating film (18), and an n-side metal pillar (24) provided on the n-side interconnection layer (22), the n-side metal pillar (24) being thicker than the n-side interconnection layer (22).
